# EUROPEAN PATENT APPLICATION

(11) **EP 4 415 027 A1**
(43) Date of publication of application: **14.08.2024**
(21) Application number: 23155900.6
(22) Date of filing: 09.02.2023
(51) Int. Cl.: H01L 21/265, H01L 21/762

(54) **SEMICONDUCTOR DEVICE AND METHODS FOR FABRICATING A SEMICONDUCTOR DEVICE**

(71) Applicant: Infineon Technologies AG, 85579 Neubiberg (DE)
(72) Inventor: TADDIKEN, Hans, 81737 Munchen (DE)
(74) Representative: JENSEN & SON

(57) **Abstract**

In an embodiment, a semiconductor device is provided that comprises an active crystalline semiconductor layer comprising a first major surface and one or more active semiconductor devices, a trench comprising electrically insulating material, the trench being formed in the first major surface, and at least one trap rich region formed in the active crystalline semiconductor layer. The trap rich region comprises at least one of the group consisting of oxygen atoms, nitrogen atoms and carbon atoms and is arranged laterally adjacent the trench and/or under the trench and/or at the interface between the electrically insulating material and the active crystalline semiconductor layer.

## Description

### BACKGROUND

Semiconductor devices may be used in various applications including high-frequency applications such as radiofrequency (RF) communication circuits. In high frequency applications, a semiconductor on insulator (SOI) technology may be used in which the semiconductor region, in which the semiconductor devices and circuitry are formed, is isolated from a bulk substrate by an electrically insulating layer. This arrangement is used to reduce parasitic capacitance and improve the quality and performance of the semiconductor devices and circuitry. US Patent No. 10,460, 983 B1 describes a method for fabricating a bonded SOI type substrate for an RF device.

It is desirable to further improve the performance of semiconductor devices for use in high-frequency applications.

### SUMMARY

According to the invention, a semiconductor device is provided that comprises an active crystalline semiconductor layer comprising a first major surface, one or more active semiconductor devices, a trench comprising electrically insulating material, the trench being formed in the first major surface, and at least one trap rich region formed in the active crystalline semiconductor layer. The trap rich region comprises at least one of the group consisting of oxygen atoms, nitrogen atoms and carbon atoms and is arranged laterally adjacent the trench and/or under the trench and/or at the interface between the electrically insulating material and the active crystalline semiconductor layer.

As used herein, the term "trap rich region" refers to a region of a semiconductor material having a high density of electrically active carrier traps. In some embodiments, the trap rich region comprises a greater number of recombination sites than the active crystalline semiconductor layer. The trap rich region serves to provide localised energy state acting for trap and release and /or a higher recombination rate for free charge carriers, e.g. holes or electrons, than the crystalline regions of the crystalline semiconductor layer. Thus, during RF operation of the active semiconductor devices, movement of the charge carriers is prevented and the formation of parasitic capacitances and the suppression of parasitic RF capacitances is achieved. This results in lower losses and improved performance of the semiconductor device.

The oxygen atoms and/or nitrogen atoms and/or carbon atoms may be present as ions or atoms or both ions and atoms. The one or more of the group of oxygen atoms or ions, nitrogen atoms or ions and carbon atom or ions serve to hinder the recrystallization of the trap rich region, for example during subsequent processing at higher temperatures, e.g. annealing, and during operation of the device. By hindering the recrystallization of the trap rich region, the beneficial effects of the trap rich region are more reliably achieved in the final semiconductor device.

The trap rich region is located within the active semiconductor layer and may have the form of a buried layer or region that is spaced apart from the opposing major surfaces of the crystalline semiconductor layer. The trap rich region may be located at positions in which parasitic capacitances may, in the absence of the trap rich region, occur. For example, the trap rich region may be positioned at the interface between the electrically insulating material in the trench and the semiconductor material so that a disrupted crystalline region is formed between the electrically insulating material in the trench and the crystalline semiconductor of the active crystalline semiconductor layer. The trap rich region may be formed under and spaced part from the active semiconductor devices by a portion of the crystalline semiconductor layer, e.g. under and spaced apart from a channel region of a lateral transistor device. In some embodiments, the trench is filled with electrically insulating material.

In some embodiments, the trap rich region comprises a disrupted crystalline structure. In some embodiments, the trap rich region comprises a damaged or implanted structure.

In some embodiments, the trap rich region comprises amorphous semiconductor material.

In some embodiments, the trap rich region comprises a disrupted crystalline structure and argon atoms in addition to at least one of the group consisting of oxygen atoms, nitrogen atoms and carbon atoms. The argon atoms may be present as argon ions or atoms or both ions and atoms.

Ar atoms or ions may be used at least substantially damage or destroy the lattice structure of the crystalline region. Argon may beneficially be employed because it has a relatively large mass, so it will do substantial damage; but it is also inert, so it will not cause any unexpected side effects. The A atoms and ions, if present, do not have a doping effect on the material of the semiconductor substrate and are electrically inactive in the band structure of the material of the semiconductor substrate. Oxygen or carbon or nitrogen may be beneficially used as they can form a more stable trap density with respect to subsequent thermal annealing due to the formation of Si-O or Si-C bonds, which disrupt the silicon crystal lattice, leaving some Si bonds dangling. In addition, with sufficient dose and subsequent thermal annealing, O atoms may start to coalesce, forming SiOx precipitates, which will form stable trap sites in the silicon lattice.

In some embodiments, the maximum concentration of oxygen atoms, nitrogen atoms and carbon atoms in the trap-rich region lies within the range of 1e¹⁹cm³ to 2e²²cm³.

Multiple implant energies can be used to form the trap rich layer by implanting particles, e.g. atoms of ions of O, C and/or N into the first major surface to a maximum desired depth or distance from the first major surface. Also, the dose can also be varied with the energy to create an almost constant trap density vs. depth.

The active crystalline semiconductor layer may be formed of monocrystalline silicon or epitaxial crystalline silicon. The electrically insulating material in the trench may comprise silicon dioxide or two or more sublayers of differing electrically insulating materials, for example silicon nitride and silicon dioxide.

In some embodiments, the trench is arranged laterally adjacent one or more of the active semiconductor devices. The trench may be arranged laterally between two active semiconductor devices, for example. One or more passive devices, e.g. a resistor, or an electrically conductive interconnect, e.g. a metal interconnect, may be located on the electrically insulating material that is positioned in the trench. One or more of the passive devices may be electrically connected to one or more of the active semiconductor devices to form a circuit, for example an amplifier circuit.

In some embodiments, at least one of the active semiconductor devices is a lateral transistor device. The lateral transistor device comprises a source region and a drain region each comprising a second conductivity type, which opposes the first conductivity type of the active crystalline semiconductor layer. The first conductivity type may be p-type and the second conductivity type n-type, or vice versa. The drain region is laterally spaced apart from the source region and a gate electrode is arranged laterally between the source region and the drain region. The source region and the drain region are formed in the crystalline semiconductor layer and may extend to the first major surface. The gate electrode may be arranged on a gate dielectric that is arranged on the first major surface.

In some embodiments, the active crystalline semiconductor layer is a bulk semiconductor substrate, for example a bulk silicon substrate, formed of monocrystalline semiconductor, e.g. monocrystalline silicon. The bulk semiconductor substrate comprises a second major surface that opposes the first major surface and that forms a rear surface of the semiconductor device. For example, the active crystalline semiconductor layer may have the form of a monocrystalline silicon die.

In some embodiments, the semiconductor device further comprises a base substrate and an electrically insulating layer arranged on the base substrate. The active crystalline semiconductor layer is arranged on the electrically insulating layer such that the first major surface faces away from the base substrate. Such an arrangement may be referred to as a semiconductor on insulator (SOI) substrate.

In some embodiments, the semiconductor device further comprises a doped crystalline semiconductor region that is doped so as to have the first conductivity type. The doped crystalline layer is formed at at least part of the interface between the electrically insulating material in the trench and the active crystalline semiconductor layer. The active crystalline semiconductor layer has the first conductivity type and the doped crystalline semiconductor layer is more highly doped than the active crystalline semiconductor layer. In some embodiments, the first conductivity type is p-type.

A DC voltage between the interconnect and the substrate, which may be required for the functionality of the switch, and/or the presence of electrical charges in a dielectric between the interconnect and the substrate may result in the formation of an accumulation or inversion layer at an interface between the metal interconnect and the dielectric. For example, an n-conducting inversion layer may form in a lightly p-doped substrate. The capacitive coupling of the charge carriers in the inversion layer to a high-frequency signal carried by the interconnect may have a negative impact on the signal, e.g. damped or distorted. The doped crystalline layer provides a selective counter doping of the surface channel is used to suppress the inversion layer. The term "counter doping" indicates that a conductivity type of this doping is opposite to a conductivity type of an inversion layer that is to be suppressed. For example, in case of an n-conducting inversion layer, a p-type counter doping is used.

In some embodiments, the semiconductor device further comprises a metallization structure on the first major surface of the active crystalline semiconductor layer. The metallization structure comprises at least one exposed contact pad. The metallization structure provides an electrically conductive redistribution structure and may electrically connect the some or all of the active semiconductor devices to one another, e.g. electrically connect a plurality of transistor devices in parallel. The metallization structure may also provide part of a circuit, for example a RF circuit including passive devices such as a resistor. The one or more contact pads may be used to electrically access the active semiconductor devices., e.g. supply or receive a voltage or signals to and from the active semiconductor devices.

A method for fabricating a semiconductor device according to an embodiment of the invention is provided. The method comprises implanting argon ions into an active crystalline semiconductor layer and forming an implanted region in the active crystalline semiconductor layer, wherein the active crystalline semiconductor layer comprises a first major surface and a trench comprising electrically insulating material, the trench being formed in the first major surface. The method further comprises implanting at least one of the group consisting of oxygen particles, nitrogen particles and carbon particles into the implanted region and forming a trap rich region in the active crystalline semiconductor layer. The trap rich region is arranged laterally adjacent to the trench and/or under the trench and/or at the interface between the electrically insulating material and the semiconductor layer.

The particles of argon, oxygen, nitrogen or carbon that are implanted may be atoms or ions. The trap rich region comprises argon ions and one or more of oxygen, nitrogen and carbon.

The implantation of the argon ions forms an implanted region having a damaged, i.e. disrupted crystal structure. The region comprising the one or more of oxygen, nitrogen and carbon may be implanted into some or all of the implanted region comprising argon.

In some embodiments, the crystalline semiconductor layer comprises one or more active semiconductor devices before implantation of the argon ions. In other embodiments, the one or more active semiconductor devices are formed after implanting the argon ions and after implanting the oxygen and/or nitrogen and/or carbon particles.

A method for fabricating a semiconductor device according to an embodiment of the invention is provided. The method comprises forming an amorphous semiconductor layer on or in an active crystalline semiconductor layer that comprises a first major surface and a trench comprising electrically insulating material, the trench being formed in the first major surface. The method further comprises implanting at least one of the group consisting of oxygen particles, nitrogen particles and carbon particles into the amorphous layer and forming a trap rich region formed in the active crystalline semiconductor layer. The trap rich region is arranged laterally adjacent to the trench and/or under the trench and/or at the interface between the electrically insulating material and the semiconductor layer.

In some embodiments, one or more active semiconductor devices formed in the active crystalline semiconductor layer before formation of the amorphous semiconductive layer. In some embodiments, the one or more active semiconductor devices are formed after the formation of the amorphous semiconductor layer.

The amorphous semiconductor layer may be formed by deposition of an additional layer of an amorphous semiconductor, e.g. amorphous silicon or by implantation, e.g. by implantation of argon ions into the crystalline semiconductor layer to amorphize a region of the crystalline semiconductor layer.

The particles of oxygen, nitrogen or carbon that are implanted may be atoms or ions. The particles of oxygen, nitrogen and/or carbon may be implanted into some or all of the amorphous semiconductor layer.

One or more of the argon, oxygen, nitrogen and carbon particles may be implanted with an implantation energy of 5keV to 600keV. Two or more implantations using differing energies may be used, for example to form a trap rich region having a greater depth.

In some embodiments, the method further comprises forming the trench in the first major surface, the trench comprising a base and sidewalls extending from the base to the first major surface. The trench may be formed after depositing the amorphous layer, for example by means of etching through the amorphous layer and etching partially into the crystalline region of semiconductor layer. Alternatively, the trench may be formed before forming the amorphous layer.

In some embodiments, the method further comprises implanting dopants of a first conductivity type into the sidewall and the base of the trench and afterwards filling the trench with the electrically insulating material. Implanting dopants of a first conductivity type into the sidewall and the base of the trench may form a region having a higher doping concentration of dopants of the first conductivity type than the doping concentration of these dopants in the contiguous regions of the active crystalline semiconductor layer.

For an active crystalline semiconductor layer formed of silicon, boron or phosphorous dopants may be used. The first conductivity type may be p-type and the dopants of the first conductivity type are boron. The second conductivity type may be n-type and the dopants of the first conductivity type are phosphorous.

In some embodiments, after implanting the dopants of the first conductivity type into the base and sidewall of the trench, the method comprises implanting the at least one of the group consisting of oxygen particles, nitrogen particles and carbon particles to form the trap-rich region.

In some embodiments, the method further comprises lining the base and sidewall of the trench with an electrically insulating liner layer and then implanting the dopants of the first conductivity type into the base and sidewall of the trench. The liner layer may act as a scattering layer. After implanting the dopants of the first conductivity type into the base and sidewall of the trench and after implanting the argon and the oxygen particles and/or nitrogen particles and/or carbon particles, the trench may be filled with the electrically insulating material. The oxygen particles and/or nitrogen particles and/or carbon particles may be implanted into the active crystalline layer through the base and/or side walls of the trench. If Ar implantation is used to form a disrupted crystal structure for the trap rich region, argon may be implanted into the active crystalline layer through the base and/or side walls of the trench.

In some embodiments, the method further comprises subjecting the active crystalline semiconductor layer to an annealing treatment. The annealing treatment may be used as part of the process to form one or more of the active semiconductor devices in the active crystalline semiconductor layer, for example to form the source and drain regions of a transistor device, or a metallization structure on the first major surface of the active crystalline semiconductor layer.

The presence of the trap rich region effectively combats parasitic surface conduction because the trap rich layer significantly degrades the carrier lifetimes of the charge carriers in the region. Since the carriers cannot travel far, therefore, the effective resistance of the substrate layer is preserved and the capacitance as seen by the active layer is not as dependent upon the signals in the active layer.

If the trap rich layer is formed prior to the subsequent processing for the formation of the structures in the active layer, these later processing steps can degrade the trap rich layer. Processing of semiconductor devices and in particular the production of active devices in the active layer generally involves high temperature processes conducted at temperatures from 1000° C. to 1100° C. High temperature processing of semiconductor structures acts to anneal defects in a semiconductor crystal lattice. This effect is commonly utilized to enhance the electrical properties of electrical circuits. However, contrary to usual applications, the performance of trap rich layers formed from amorphous or polycrystalline silicon crystal patterns is actually decreased when imperfections are annealed out since the number of traps is decreased. This decrease in the number of traps is reduced or even prevented by the additional implantation of O, C and/or N particles which provide more stable charge traps.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1 illustrates a cross-sectional view of a semiconductor device according to an embodiment.
Figure 2 illustrates a semiconductor device according to an embodiment.
Figure 3A illustrates a method of fabricating a semiconductor device according to an embodiment.
Figure 3B illustrates a method of fabricating a semiconductor device according to an embodiment.
Figure 4 illustrates a flowchart of a method for fabricating a semiconductor device according to an embodiment.
Figure 5 illustrates a flowchart of a method for fabricating a semiconductor device according to an embodiment.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The Figures illustrate relative doping concentrations by indicating "-" or "+" next to the doping type "n" or "p". For example, "n⁻" means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

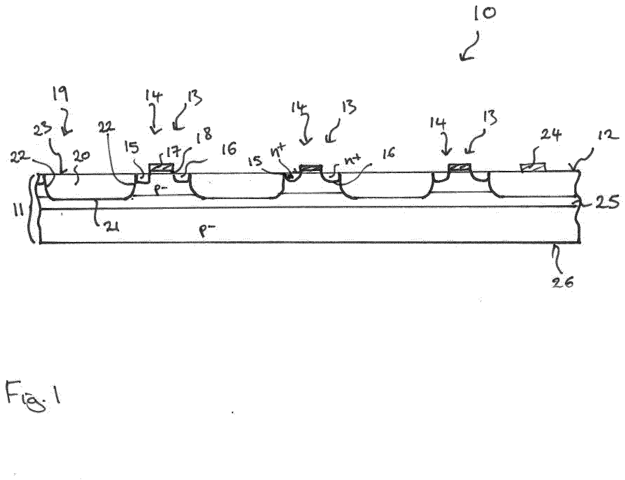

Figure 1 illustrates a cross-sectional view of a semiconductor device 10 according to an embodiment. The semiconductor device 10 comprises an active semiconductor layer 11 comprising a first major surface 12 and one or more active crystalline semiconductor devices 13 formed in and/or on the active crystalline semiconductor layer 11. The active crystalline semiconductor layer 11 may be formed of a semiconductor die or wafer which is formed of monocrystalline semiconductor, for example monocrystalline silicon, or an epitaxial layer, for example epitaxial silicon. The active crystalline semiconductor layer 11 is, in the embodiment illustrated in figure 1, not part of a semiconductor on insulator (SOI) structure but is a bulk substrate in which the second major surface 26, which opposes the first major surface 12, of the active crystalline layer 11 provides the rear surface of the semiconductor device 10. The active crystalline semiconductor layer 11 comprises a first conductivity type, which may be p-type, and lightly doped.

In some embodiments, one or more of the active semiconductor devices 13, which are formed in the active crystalline semiconductor layer 11, is a lateral transistor device 14 that comprises a source region 15, a drain region 16 and a gate 17. The source region 15 formed in the first major surface 12 and is doped with a second conductivity type. The drain region 16 is also doped with the second conductivity type and formed in the first major surface 12 laterally spaced apart from the source region 15. The gate electrode 17 is arranged on the first major surface 12 and laterally between the source region 15 and drain region 16. The gate electrode 17 may be formed of polysilicon and is situated on a gate dielectric 18 which is positioned between the gate electrode 17 and the first major surface 12 of the active crystalline semiconductor layer 11. The second conductivity type is n-type, if the first conductivity type is p-type.

The semiconductor device 10 further comprises one or more trenches 19 which are formed in the first major surface 12 of the semiconductor layer 11 and which comprise an electrically insulating material 20, for example SiO₂. Each trench 19 has a base 21 and sidewalls 22 which extend from the base 21 to the first major surface 12. The trench 19 may provide shallow trench insulation. The trench 19 may be arranged between adjacent ones of the active transistor devices 14. In some embodiments, the uppermost portion of opposing sidewalls 22 of the trench is formed by the drain region 16 and by the source region 15, respectively, of two neighbouring ones of the transistor devices 14. The trench 19 may be filled with the electrically insulating material 20 such that the upper surface of the electrically insulating material 20 is substantially coplanar with the first major surface 12 of the active crystalline semiconductor layer 11. In some embodiments one or more passive devices 24 may be formed on and/or in the electrically insulating material 20. For example, a resistor formed of electrically conductive material, e.g. polysilicon, or an interconnect, such as a metal trace, may be formed on the electrically insulating material 20 and above the trench 19.

The semiconductor device 10 further comprises at least one trap region 25 which is formed in the active crystalline semiconductor layer 11. The trap region 25 comprises a greater number of recombination sites than the active crystalline semiconductor layer 11. These recombination sites significantly degrade the carrier lifetimes of charge carriers within this region 25 in order to combat parasitic conduction. The trap region 25 may be referred to as a buried layer or region as it is positioned in the active crystalline semiconductor layer 11 and spaced apart from the first major surface 12 and the opposing second major surface by a portion of the active crystalline semiconductor layer 11.

In some embodiments, the trap rich region 25 is formed by a damaged region of the active crystalline semiconductor layer 11 which comprises a disrupted crystalline structure. The damaged layer may be formed by implantation of particles, for example Ar ions, into the active crystalline semiconductor layer 11. The trap rich region 25 further comprises at least one of the group consisting of oxygen particles, nitrogen particles and carbon particles. The oxygen, nitrogen and carbon particles may be atoms or ions. The oxygen, nitrogen and/or carbon atoms or ions may be located in some or all of the disrupted crystalline region. The region of the active semiconductor layer 11 which comprises the disrupted crystalline structure may partially or completely overlap the region of the semiconductor layer 11 that comprises the oxygen, nitrogen and/or carbon atoms or ions.

In some embodiments, the trap rich region 25 comprises amorphous semiconductor material. In some embodiments, the amorphous semiconductor material of the trap rich region 25 is formed by implantation, e.g. of Ar ions, which causes the local amorphization of the crystalline structure of the semiconductor layer 11 or by depositing an additional layer of amorphous material on the crystalline semiconductor layer 11. The trap rich region 25 further comprises at least one of the group consisting of oxygen particles, nitrogen particles and carbon particles located in the amorphous semiconductor material. The oxygen, nitrogen and carbon particles may be atoms or ions. The oxygen, nitrogen and/or carbon atoms or ions may be positioned in some or all of the amorphous semiconductor region.

The one or more of the oxygen, nitrogen and carbon particles serve to prevent or hinder the recrystallisation of the disrupted crystalline structure or amorphous semiconductor material when the semiconductor device 10 is subjected to increased temperatures, for example, annealing, during subsequent processing steps, for example to fabricate the transistor devices 14 and/or the passive device(s) 24. The concentration of oxygen atoms, nitrogen atoms and carbon atoms in the trap rich region 25 may lie within the range of 1e¹⁹ cm³ to 2e²² cm³.

The trap rich region 25 may have different positions within the active crystalline semiconductor layer 11. For example, the trap rich region 25 may be arranged laterally adjacent to the trench 19, e.g. between adjacent ones of the trenches 19, or under the base 21 of the trench 19 or at the interface formed between the electrically insulating material 20 within the trench 19 and the active crystalline semiconductor layer 11 or combinations of these arrangements. In some embodiments, the trap rich region 25 forms the base 21 of the trench 19 and optionally a part of the side wall 22 of the trench 19.

In some embodiments, such as the semiconductor device illustrated in figure 1, the trap rich region 25 may have the form of a buried layer which is spaced apart from the first major surface 12 and from the second major surface 26 of the active crystalline semiconductor layer 11. The trap rich region 25 is positioned under the base 21 of the trench 19, laterally adjacent the sidewall 22 of the trench 19 and underneath the transistor device 14 and also forms an interface with at least the electric insulating material 20 positioned on the base 21 of the trench 19.

The trap rich region 25 may have the form of a continuous buried layer that extends under the trenches 19 and active transistor devices 14 or may have the form of a plurality of subregions that are spaced apart from one another by crystalline regions of the active crystalline layer 11. The subregions of the trap rich region 25 may be formed as isolated discrete bubbles. One bubble may be positioned under the base 21 of each trench 19 such that it is not positioned under the source region 14, gate 17 and drain region 16 of the lateral transistor device 14.

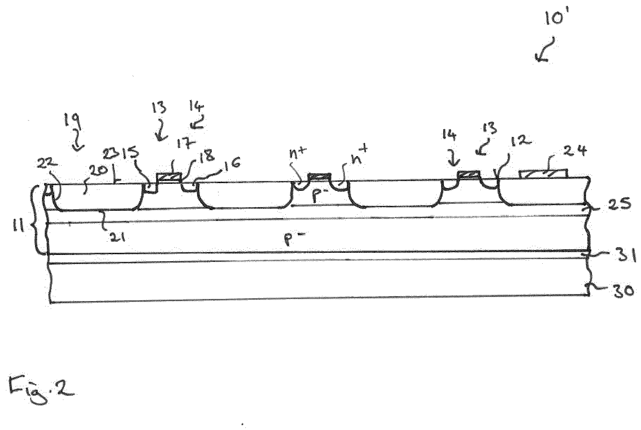

Figure 2 illustrates this semiconductor device 10' according to an embodiment which differs from the semiconductor device 10 illustrated in figure 1 in that the semiconductor device 10' comprises a SOI-type substrate rather than a bulk substrate. The semiconductor device 10' further comprises a base substrate 30 and an electrically insulating layer 31 arranged on the base substrate 30. The active crystalline semiconductor layer 11 is arranged on the electrically insulating layer 11 such that the first major surface 12 faces away from the base substrate 30. The electrically insulating layer 31 is arranged between the base substrate 30 and the active crystalline semiconductor layer 11. The trap rich region 25 is spaced apart from the plane of the first major surface 12 by a portion of the active crystalline semiconductor layer 11. Since, the trap rich region 25 is positioned within the active crystalline semiconductor layer 11, it is also spaced apart from the electrically insulative layer 31 by a lower portion of the active crystalline semiconductor layer 11.

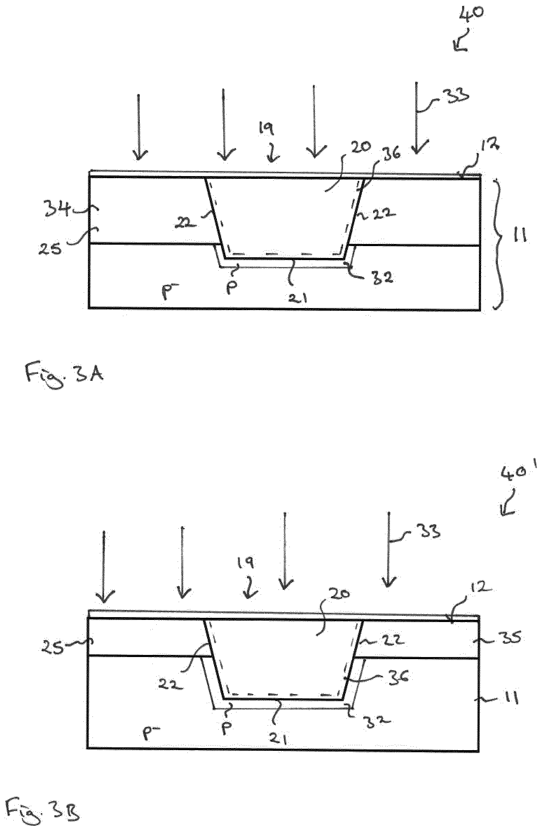

A method for fabricating a semiconductor device, which may be used to fabricate the semiconductor device of any one of the embodiments described herein including that illustrated in and described with reference to figures 1 or 2 will now be described with reference to figure 3.

Figure 3A illustrates a cross-sectional view of a portion of a semiconductor device 40 which comprises a crystalline semiconductor layer 11 comprising a first major surface 12 and a trench 19 positioned in the first major surface 12. The trench is filled with the electrically insulating material 20 which also extends over the first major surface 12. The semiconductor device 40 further comprises a doped crystalline region 32, which is doped with the first conductivity type, and which is formed at the base 21 and sidewalls 22 of the trench 19 such that it forms an interface with the electrically insulating material 20 within the trench and with the active crystalline semiconductor layer 11. The doped crystalline layer 32 is more highly doped than the active crystalline semiconductor layer 11 which also has the first conductivity type.

The doped crystalline layer 32 is formed by implanting dopants of the first conductivity type, e.g. boron, into the base 21 and side walls 22 of the trench 19 so that the doped crystalline layer 32 forms the base 21 and side walls 22 of the trench 19. The trench 19 is then filled with the electrically insulating material 20. In some embodiments, a liner layer 36 is formed over the base 21 and side walls 22 of the trench 19 and the dopants of the first conductivity type implanted through the liner layer, base 21 and side walls 22 of the trench 19. The trench 19 is subsequently filled with the electrically insulating material 20.

Ar ions are implanted into the first major surface 12 of the crystalline active crystalline semiconductor layer 11, as is indicated by schematically by the arrows 33, and a damaged layer 34 with a disrupted non-crystalline structure is formed in the active crystalline semiconductor layer 11. Afterwards, particles of one or more of oxygen, nitrogen and carbon are implanted into the damaged region 34, as is also schematically indicated by the arrows 33, to form the trap rich region 25. The oxygen, nitrogen and or carbon species may be atoms or irons and serve to hinder the recrystallisation of the damaged region 34 during subsequent processing of the device at raised temperatures.

At this stage in the manufacturing process, the active semiconductor devices 13, such as the transistor device 14 shown in figures 1 and 2, have not yet been fabricated. Subsequently, the gate electrode 17 is formed on the first major surface 12 and the dopants of the second conductivity type are locally implanted into the first major surface 12 of the active crystalline semiconductor layer 11 to form the source region 15 and drain region 16. A subsequent annealing treatment is carried out to form the source region 15 and drain region 16.

In some embodiments, the active semiconductor devices 13, such as the transistor device 14 shown in figures 1 and 2, are fabricated before the implantation of the Ar ions into the first major surface 12 of the crystalline active crystalline semiconductor layer 11 to form the damaged layer 34 with a disrupted non-crystalline structure and the implantation of particles of one or more of oxygen, nitrogen and carbon into the damaged region 34 to form the trap rich region 25.

Figure 3B illustrates a semiconductor device 40' according to an embodiment which differs from that illustrated in figure 3A in that an amorphous region 35 is formed at the upper surface of the crystalline semiconductor layer 11. The amorphous region 35 may be formed by implantation of Ar ions into the active crystalline semiconductor layer 11 which causes the amorphization of the crystal structure to form an amorphous silicon layer at the first major surface 12 or by the deposition of amorphous material, e.g. amorphous silicon.

Similar to the semiconductor device 40 described with reference to figure 3A, a trench 19 is formed in the first major surface 12, for example by etching and the doped crystalline layer 32 is formed by implanting dopants of the first conductivity type into the base 21 and side walls 22 of the trench 19 so that the doped crystalline layer 32 forms the base 21 and side walls 22 of the trench 19 and forms an interface with the electrically insulating material 20 within the trench 19 and with the active crystalline semiconductor layer 11. The doped crystalline layer 32 is more highly doped than the active crystalline semiconductor layer 11. Particles of one or more of oxygen, nitrogen and carbon are implanted into the first major surface 12 to form the amorphous region 35, as is schematically indicated by the arrows 33, to form the trap rich region 25. The oxygen, nitrogen and or carbon species may be atoms or irons and serve to hinder the recrystallisation of the amorphous region 35 during subsequent processing of the device at raised temperatures.

The doped layer 32 may be useful for high-frequency transistors that are connected to one another by electrically conductive interconnects that may also extend from the transistor devices to the contact pads of a chip, since a parasitic capacitance may form between the interconnects and the crystalline semiconductor layer 11.

A DC voltage between the interconnect and the crystalline semiconductor layer 11 may be required for the functionality of the switch. The presence of electrical charges in the electrically insulating material 20 located in the trench 19 between the interconnect and the crystalline semiconductor layer 11 may lead to the formation of an accumulation or inversion layer at the interface between the metal interconnect and the electrically insulating material 20. For example, an n-conducting inversion layer may form in a commonly used lightly p-doped substrate. The capacitive coupling of the charge carriers in the inversion layer to the high-frequency signal carried by the interconnect may have a negative impact on the signal, e.g. the signal may be damped or distorted.

The doped crystalline semiconductor layer 32 provides a selective counter doping of the surface channel is used to suppress the inversion layer. The term "counter doping" indicates that a conductivity type of this doping is opposite to a conductivity type of an inversion layer that is to be suppressed. For example, in case of an n-conducting inversion layer, a p-type counter doping is used.

This counter doping may be introduced via a first implantation into the shallow trench isolation (STI) 19, which is still open then (i.e., not completely filled with insulating material 20), and, as a second implantation, ions (e.g., argon ions) are be implanted with a high dose into regions adjacent or between the STI region(s). Thus, an amorphous region or a region with a disrupted crystal structure may be formed in the substrate, e.g. a region of amorphous silicon. One or more of O, C and N atoms or ions are then implanted into the amorphous region or a region with a disrupted crystal structure to form the trap rich region 25. In the trap rich region 25, electrons may recombine almost immediately with positive charge carriers. Thus, neither an accumulation channel nor an inversion channel may form in the trap rich region. This principle may sometimes be referred to as Fermi level pinning.

The insulating liner layer 36 covering the at least one sidewall 22 and the bottom 21 of the trench 19 may include or may be made of an insulating material such as, e.g., an oxide, e.g. silicon oxide, or a nitride, e.g. silicon nitride, or an oxynitride, e.g. silicon oxynitride, or the like. The insulating liner layer 36 may have a thickness in the range from about 2 nm to about 50 nm.

The insulating material 20 may comprise or be an oxide, e.g. silicon oxide, or an oxynitride, e.g. silicon oxynitride, or a nitride, e.g. silicon nitride. The insulating material 20 may include or may be the same material as the material of the insulating liner layer 36.

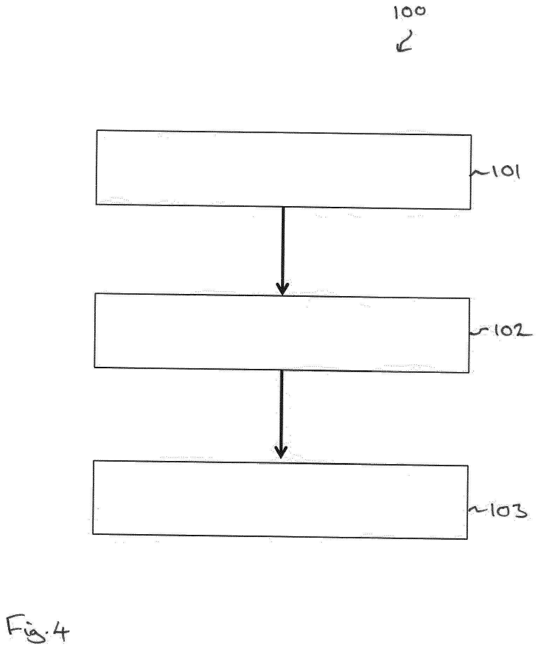

Figure 4 illustrates a flowchart of a method for according to an embodiment for fabricating a semiconductor device. In block 100 an active semiconductor layer is provided which comprises a first major surface and a trench formed in the first major surface which comprising electrically insulating material. In some embodiments, one or more active crystalline semiconductor devices are formed in the active crystalline semiconductor layer. In block 101, Ar irons are implanted into the active crystalline semiconductor layer to form an implanted region within the active crystalline semiconductor layer that is spaced apart from the opposing major surfaces of the active crystalline semiconductor layer. The implanted region may have a damaged crystal structure, e.g. disrupted crystal structure, or may be amorphous. In block 102, at least one of the group consisting of oxygen atoms or ions, nitrogen atoms or ions and carbon atoms or ions are implanted into the implanted region and a trap rich region is formed in the active crystalline semiconductor layer. The trap rich region may be arranged laterally adjacent to the trench and/or under the trench and/or at the interface between the electrically insulating material within the trench and the active crystalline semiconductor layer.

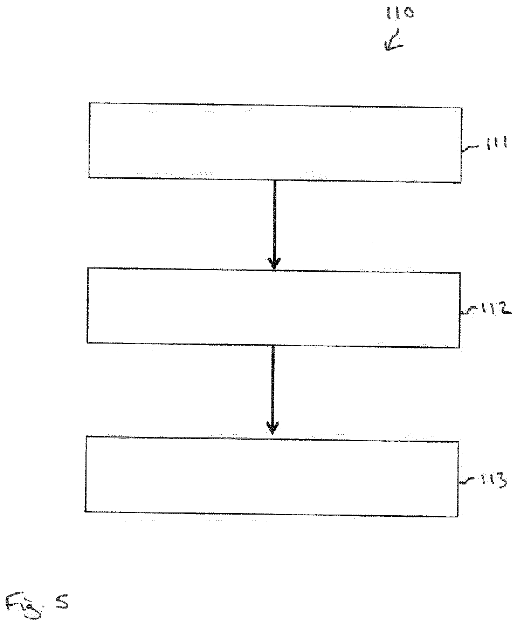

Figure 5 illustrates a flowchart of a method according to an embodiment for fabricating a semiconductor device. In block 110, an active crystalline semiconductor layer is provided which comprises first major surface. One or more active semiconductor devices may be positioned in the active crystalline semiconductor layer. A trench is formed in the first major surface of the active crystalline semiconductor layer and may be filled with electrically insulating material. In block 111, an amorphous semiconductor layer is formed on or in the active crystalline semiconductor layer. For example, an amorphous semiconductor layer may be deposited onto the first major surface or may be formed at the first major surface, for example, by implantation.

In block 112, one or more of oxygen atoms or ions, nitrogen atoms or ions and carbon atoms or ions are implanted into the amorphous layer to form a trap rich region formed on or in the active crystalline semiconductor layer. Again, the trap rich region is arranged laterally adjacent to the trench and/or under the trench and/or at the interface between the electrically insulating material within the trench and the active crystalline semiconductor layer.

The Ar, oxygen, nitrogen and carbon atoms or irons may be implanted into the active crystalline semiconductor layer with an implantation energy of 5keV to 600keV.

In some embodiments, after forming the trench in the first major surface of the active crystalline semiconductor layer, for example, by etching, dopants of the first conductivity type are implanted into the sidewall and the base of the trench and afterwards the trench is filled with electrically insulating material. In some embodiments, after the dopants of the first conductivity type are implanted into the basin sidewall of the trench, the one or more the oxygen atoms, nitrogen atoms and carbon atoms are implanted and then the trenches filled with electrically insulating material.

In some embodiments, after forming the trench with this base and sidewalls, the base and sidewalls of the trench are lined with an electrically insulating layer, for example, silicon dioxide, which may be deposited or thermally grown. Afterwards the dopants of the first conductivity type are implanted into the base and sidewall of the trench. The trench is then filled with electrically insulating material.

The active crystalline semiconductor layer may subsequently be subjected to higher temperature, e.g. 1000°C or greater an annealing treatment. The recrystallisation of the damaged crystal structure or amorphous layer in which the trap rich region is formed is hindered and, in some embodiments, prevented due to the presence of one or more of oxygen, nitrogen and carbon atoms or ions.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor device, comprising:
an active crystalline semiconductor layer comprising a first major surface and one or more active semiconductor devices;
a trench comprising electrically insulating material, the trench being formed in the first major surface;
at least one trap rich region formed in the active crystalline semiconductor layer;
wherein the trap rich region comprises at least one of the group consisting of oxygen atoms, nitrogen atoms and carbon atoms and is arranged laterally adjacent the trench and/or under the trench and/or at the interface between the electrically insulating material and the active crystalline semiconductor layer.

2. A semiconductor device according to claim 1, wherein the trap rich region comprises amorphous semiconductor material or a disrupted crystalline structure.

3. A semiconductor device according to claim 1, wherein the trap rich region comprises a disrupted crystalline structure and argon atoms.

4. A semiconductor device according to any one of claims 1 to 3, wherein the maximum concentration of oxygen atoms, nitrogen atoms and carbon atoms in the trap-rich region lies within the range of 1e¹⁹cm³ to 2e²²cm³.

5. A semiconductor device according to any one of claims 1 to 4, wherein the trench is arranged laterally adjacent one or more of the active semiconductor devices.

6. A semiconductor device according to any one of claims 1 to 5, wherein at least one of the active semiconductor devices is a lateral transistor device.

7. A semiconductor device according to any one of claims 1 to 6, wherein the active crystalline semiconductor layer is formed of monocrystalline silicon or epitaxial crystalline silicon.

8. A semiconductor device according to any one of claims 1 to 7, wherein the active crystalline semiconductor layer comprises a second major surface that opposes the first major surface and that forms a rear surface of the semiconductor device.

9. A semiconductor device according to any one of claims 1 to 8, further comprising a doped crystalline semiconductor region that is doped with a first conductivity type and that is formed at at least part of the interface between the electrically insulating material in the trench and the active crystalline semiconductor layer, wherein the active crystalline semiconductor layer has the first conductivity type and the doped crystalline semiconductor layer is more highly doped than the active crystalline semiconductor layer.

10. A semiconductor device according to any one of claims 1 to 9, further comprising a metallization structure on the first major surface of the active crystalline semiconductor layer, wherein the metallization structure comprises at least one exposed contact pad.

11. A method for fabricating a semiconductor device, the method comprising:
implanting argon ions into an active crystalline semiconductor layer and forming an implanted region in the active crystalline semiconductor layer, wherein the active crystalline semiconductor layer comprises a first major surface and one or more active crystalline semiconductor devices and a trench comprising electrically insulating material, the trench being formed in the first major surface,
implanting at least one of the group consisting of oxygen atoms, nitrogen atoms and carbon atoms into the implanted region and forming a trap rich region in the active crystalline semiconductor layer,
wherein the trap rich region is arranged laterally adjacent to the trench and/or under the trench and/or at the interface between the electrically insulating material and the semiconductor layer.

12. A method for fabricating a semiconductor device, the method comprising:
forming an amorphous semiconductor layer on or in an active crystalline semiconductor layer comprising a first major surface and one or more active crystalline semiconductor devices and a trench comprising electrically insulating material, the trench being formed in the first major surface,
implanting at least one of the group consisting of oxygen atoms, nitrogen atoms and carbon atoms into the amorphous layer and forming a trap rich region formed in the active crystalline semiconductor layer,
wherein the trap rich region is arranged laterally adjacent to the trench and/or under the trench and/or at the interface between the electrically insulating material and the semiconductor layer.

13. A method according to claim 11 or claim 12, further comprising:
forming the trench in the first major surface, the trench comprising a base and sidewalls extending from the base to the first major surface and
implanting dopants of a first conductivity type into the sidewall and the base of the trench and afterwards filling the trench with the electrically insulating material.

14. A method according to claim 13, wherein after implanting the dopants of the first conductivity type into the base and sidewall of the trench, implanting the at least one of the group consisting of oxygen atoms, nitrogen atoms and carbon atoms to form the trap-rich region.

15. A method according to any one of claims 11 to 14, further comprising subjecting the active crystalline semiconductor layer to an annealing treatment.
